# EUROPEAN PATENT SPECIFICATION

(11) **EP 0 820 645 B1**
(45) Date of publication and mention of the grant of the patent: **10.07.2002**
(21) Application number: 96910275.5
(22) Date of filing: 09.04.1996
(51) Int. Cl.: H01L 29/73, H01L 27/12, H01L 23/58

(54) **BIPOLAR SILICON-ON-INSULATOR TRANSISTOR WITH INCREASED BREAKDOWN VOLTAGE**
SILIZIUM AUF ISOLATOR-BIPOLARTRANSISTOR MIT ERHÖHTER DURCHBRUCHSPANNUNG
TRANSISTOR BIPOLAIRE A SILICIUM SUR ISOLANT AVEC TENSION DE RUPTURE ACCRUE

(30) Priority: 13.04.1995 SE 9501385
(43) Date of publication of application: 28.01.1998
(73) Proprietor: TELEFONAKTIEBOLAGET LM ERICSSON, 126 25 Stockholm (SE)
(72) Inventor: LITWIN, Andrej, S-182 35 Danderyd (SE); ARNBORG, Torkel, S-113 27 Stockholm (SE)
(74) Representative: Rosenquist, Per Olof
(86) International application number: SE9600458
(87) International publication number: WO9632798

(56) References cited:
- EP-A- 0 311 419
- US-A- 4 233 618
- US-A- 4 766 482
- US-A- 4 843 448
- US-A- 4 902 633
- US-A- 5 237 193

## Description

### TECHNICAL FIELD

The invention relates to a bipolar silicon-on-insulator transistor comprising a substrate having a major surface, an oxide layer on said major surface, a silicon layer of a first conductivity type on said oxide layer, a base region of a second conductivity type extending into said silicon layer, an emitter region of said first conductivity type extending into said base region, and a collector region of said first conductivity type extending into said silicon layer at a lateral distance from said base region.

### BACKGROUND OF THE INVENTION

Such a transistor is known e.g. from the paper "Analysis of New High-Voltage Bipolar Silicon-on-Insulator Transistor with Fully Depleted Collector" by Torkel Arnborg and Andrej Litwin in IEEE Transactions on Electron Devices, Vol. 42, No. 1, January 1995 as well as from US-A-4 843 448, US-A-4 766 482 and EP-A-0 311 419.

In the known transistor, the breakdown voltage drops very sharply while increasing the substrate voltage in comparison to the emitter voltage for npn transistors and the opposite for pnp transistors. That is due to the fact that an accumulation layer is created under the emitter of the transistor, which accumulation layer for a certain substrate voltage value makes it impossible to fully deplete the collector under the emitter and lock the potential. The breakdown voltage is thus the same as it would be for a vertical transistor with buried layer and an epitaxial layer over it with similar epitaxial layer thickness and doping as the silicon-on-insulator layer, which breakdown is quite low.

Having the same requirements on the breakdown voltage for both npn and pnp transistors implies that the substrate voltage needs to be close to the middle of the applied operational voltage span. That further lowers the highest possible breakdown voltage for the transistor. Also, a soft collector breakdown or punch through may in some cases start just before the potential lock occurs for increasing collector bias.

### BRIEF DESCRIPTION OF THE INVENTION

The object of this invention is to prevent this type of breakdown by changing the electric field to reduce or prevent the creation of the accumulation layer on the collector-oxide interface under the emitter.

This is attained in the transistor according to the invention in that a plug region of said second conductivity type extends into said silicon layer up to said oxide layer on the opposite side of said emitter region relative to said collector region, that a portion of said plug region extends laterally along the surface of said oxide layer under at least part of the emitter region towards the collector region at a distance from said base region, and that said plug region is electrically connected to said base region.

Hereby, the voltage operating area will increase before breakdown occurs for the transistor with fully depleted collector.

### BRIEF DESCRIPTION OF THE DRAWING

The invention will be described more in detail below with reference to the appended drawing on which
Fig. 1 is a schematic cross-sectional view of a bipolar transistor having a plug,
Fig. 2 is a schematic cross-sectional view of an embodiment of the transistor according to the invention, and
Fig. 3 is a schematic cross-sectional view of a further bipolar transistor having a plug.

### DETAILED DESCRIPTION OF THE INVENTION

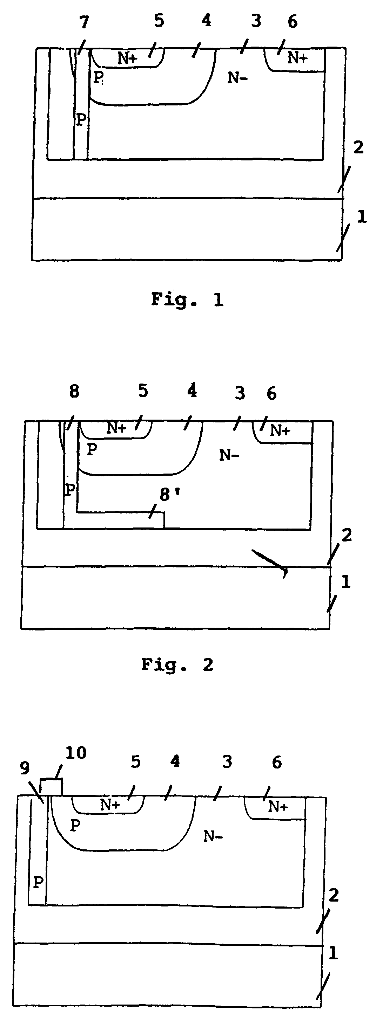

Fig. 1 shows a bipolar silicon-on-insulator (SOI) npn transistor having a plug. With reverse doping polarities, the structure applies as well to pnp transistors.

The transistor comprises a silicon substrate 1, on a major surface of which an insulating layer 2 of silicon dioxide, is provided.

A silicon layer 3 which is weakly doped with impurities of conductivity type N, is provided on the insulating oxide layer 2.

A base region 4 which is doped with impurities of conductivity type P, extends into the silicon layer 3 from the free surface thereof.

An emitter region 5 which is heavily doped with impurities of conductivity type N, extends into the base region 4 from its free surface.

At a lateral distance from the base region 4, a collector region 6 which is heavily doped with impurities of conductivity type N, extends into the silicon layer 3 from the free surface thereof.

To reduce or prevent the creation of an accumulation layer on the interface between the silicon layer 3 and the oxide layer 2 under the emitter region 5, a plug region 7 which is doped with impurities of conductivity type P, i.e. the same conductivity type as the base region, extends into the silicon layer 3 down to the oxide layer 2 on the opposite side of the emitter region 5 relative to the collector region 6.

In the device shown in Fig. 1, the plug region 7 extends completely through the base region 4 and is in electrical contact with that base region 4.

Fig. 2 shows an embodiment of the bipolar SOI transistor according to the invention.

The general design of the transistor according to Fig. 2, is the same as that of the transistor according to Fig. 1, and identical elements are provided with identical reference numerals.

The design of the plug region 8 of the transistor according to Fig. 2, differs however from that of the transistor according to Fig. 1 in that it comprises a portion 8' which extends laterally along the surface of the oxide layer 2 towards the collector region 6 at a distance from the bottom surface of the base region 4.

According to the invention, the plug region portion 8' extends laterally along the surface of the oxide layer 2 under at least part of the emitter region 5. The lateral portion 8' of the plug region 8 should at the most extend laterally up to the edge of the base region 5, facing the collector region 6.

Fig. 3 shows a further bipolar SOI transistor having a plug.

The general design of the transistor according to Fig. 3 does not differ from that of the transistors according to Figs. 1 and 2, and, consequently, identical elements are provided with the same reference numerals as the elements of the transistors according to Figs. 1 and 2.

The transistor according to Fig. 3 comprises a plug region 9 which extends down to the oxide layer 2 at a lateral distance from the base region 4.

However, the plug region 9 and the base region 4 are electrically interconnected by an external conductor 10.

The plug region 9 according to Fig. 3, may also be provided with a lateral portion (not shown) similar to the lateral portion 8' of the plug region 8 in Fig. 2.

According to a further embodiment (not shown), the plug region may extend partially through the base region 4 and partially outside the base region 4.

When, in the devices according to Figs. 1, 2 and 3, a voltage is applied between the collector 6 and the base 4, a lateral depletion of the collector region close to the plug region is started, whereby the accumulation layer at the interface between the collector and the oxide layer is reduced.

When a breakdown is caused by base punch through, the lateral field from the base region will increase the space charge layer between the base and the collector and thus delay punch through.

Also, when the breakdown is caused by impact ionization, the field redistribution from the base region will result in a lower field strength and a delay of the avalanche breakthrough.

The delay in breakdown with increasing collector voltage will be sufficient for the later occurring potential lock to protect the transistor.

The plug region 8, 8' according to Fig. 2, is more difficult to manufacture than the plug regions 7 and 9 according to Figs. 1 and 3, respectively, but all plug region embodiments contribute towards increasing the voltage operating area before breakdown for transistors with fully depleted collector.

## Claims

1. A bipolar silicon-on-insulator transistor comprising
- a substrate (1) having a major surface,
- an oxide layer (2) on said major surface,
- a silicon layer (3) of a first conductivity type on said oxide layer (2),
- a base region (4) of a second conductivity type extending into said silicon layer (3),
- an emitter region (5) of said first conductivity type extending into said base region (4),and
- a collector region (6) of said first conductivity type extending into said silicon layer (3) at a lateral distance from said base region (4), **characterized in that** a plug region (8) of said second conductivity type extends into said silicon layer (3) up to said oxide layer (2) on the opposite side of said emitter region (5) relative to said collector region (6), that a portion (8') of said plug region (8) extends laterally along the surface of said oxide layer (2) under at least part of the emitter region (5) towards the collector region (6) at a distance from said base region (4), and that said plug region is electrically connected to said base region (4).

2. A transistor as claimed in claim 1, **characterized in that** said plug region (8) extends, at least partially, through said base region (4).

3. A transistor as claimed in claim 2, **characterized in that** said plug region (8) extends completely through said base region (4).

4. A transistor as claimed in claim 1, **characterized in that** said plug region extends at a lateral distance from said base region (4).

5. A transistor as claimed in claim 4, **characterized in that** said plug region is externally connected to said base region (4).

6. A transistor as claimed in any of claims 1 - 6, **characterized in that** said portion (8') of the plug region (8) extends laterally up to the edge of the base region (4).

## Patentansprüche

1. Silizium auf Isolator-Bipolartransistor, der umfasst:
- ein Substrat (1) mit einer Hauptoberfläche,
- eine Oxidschicht (2) auf der Hauptoberfläche,
- eine Siliziumschicht (3) eines ersten Leitfähigkeittyps auf der Oxidschicht (2),
- eine Basiszone (4) eines zweiten Leitfähigkeittyps, die sich in die Siliziumschicht (3) erstreckt,
- eine Emitterzone (5) des ersten Leitfähigkeittyps, die sich in die Basiszone (4) erstreckt, und
- eine Kollektorzone (6) des ersten Leitfähigkeittyps, die sich in die Siliziumschicht (3) auf einem seitlichen Abstand von der Basiszone (4) erstreckt,
**gekennzeichnet dadurch,**
**dass** sich eine Kontaktzone (8) des zweiten Leitfähigkeittyps in die Siliziumschicht (3) bis zu der Oxidschicht (2) auf der entgegenliegenden Seite der Emitterzone (5) bezogen auf die Kollektorzone (6) erstreckt, dass sich ein Teil (8') der Kontaktzone (8) seitlich entlang der Oberfläche der Oxidschicht (2) unter zumindest einem Teil der Emitterzone (5) in Richtung der Kollektorzone (6) auf einem Abstand von der Basiszone (4) erstreckt und dass die Kontaktzone elektrisch mit der Basiszone (4) verbunden ist.

2. Transistor nach Anspruch 1, **gekennzeichnet dadurch, dass** sich die Kontaktzone (8) zumindest teilweise durch die Basiszone (4) erstreckt.

3. Transistor nach Anspruch 2, **gekennzeichnet dadurch, dass** sich die Kontaktzone (8) vollständig durch die Basiszone (4) erstreckt.

4. Transistor nach Anspruch 1, **gekennzeichnet dadurch, dass** sich die Kontaktzone auf einem seitlichen Abstand von der Basiszone (4) erstreckt.

5. Transistor nach Anspruch 4, **gekennzeichnet dadurch, dass** die Kontaktzone äußerlich mit der Basiszone (4) verbunden ist.

6. Transistor nach einem beliebigen der Ansprüche 1 bis 6, **gekennzeichnet dadurch, dass** sich der Teil (8') der Kontaktzone (8) seitlich bis zu der Kante der Basiszone (4) erstreckt.

## Revendications

1. Transistor bipolaire silicium sur isolant comportant :
- un substrat (1) ayant une surface principale,
- une couche d'oxyde (2) sur ladite surface principale,
- une couche de silicium (3) d'un premier type de conductivité sur ladite couche d'oxyde (2),
- une région de base (4) d'un second type de conductivité s'étendant jusque dans ladite couche de silicium (3),
- une région d'émetteur (5) dudit premier type de conductivité s'étendant jusque dans ladite région de base (4), et
- une région de collecteur (6) dudit premier type de conductivité s'étendant jusque dans ladite couche de silicium (3) à une certaine distance latérale de ladite région de base (4), **caractérisé en ce qu'**une région bouchon (8) dudit second type de conductivité s'étend jusque dans ladite couche de silicium (3) jusqu'à ladite couche d'oxyde (2) du côté opposé de ladite région d'émetteur (5) par rapport à ladite région de collecteur (6), **en ce qu'**une portion (8') de ladite région bouchon (8) s'étend latéralement le long de la surface de ladite couche d'oxyde (2) sous au moins une partie de la région d'émetteur (5) vers la région de collecteur (6) à une certaine distance de ladite région de base (4), et **en ce que** ladite région bouchon est reliée électriquement à ladite région de base (4).

2. Transistor selon la revendication 1, **caractérisé en ce que** ladite région bouchon (8) s'étend, au moins partiellement, à travers ladite région de base (4).

3. Transistor selon la revendication 2, **caractérisé en ce que** ladite région bouchon (8) s'étend entièrement à travers ladite région de base (4).

4. Transistor selon la revendication 1, **caractérisé en ce que** ladite région bouchon s'étend à une certaine distance latérale de ladite région de base (4).

5. Transistor selon la revendication 4, **caractérisé en ce que** ladite région bouchon est reliée extérieurement à ladite région de base (4).

6. Transistor selon l'une quelconque des revendications 1 à 6, **caractérisé en ce que** ladite portion (8') de la région bouchon (8) s'étend latéralement jusqu'au bord de la région de base (4).
